# EUROPEAN PATENT APPLICATION

(11) **EP 1 448 041 A2**
(43) Date of publication of application: **18.08.2004**
(21) Application number: 04002464.8
(22) Date of filing: 04.02.2004
(51) Int. Cl.: H05K 9/00

(54) **High-frequency device**

(30) Priority: 12.02.2003 JP 2003033346
(71) Applicant: ALPS ELECTRIC CO., LTD., Tokyo 145-8501 (JP)
(72) Inventor: Watanabe, Hirokazu, Tokyo 145-8501 (JP); Konno, Toshiaki, Tokyo 145-8501 (JP)
(74) Representative: Klunker . Schmitt-Nilson . Hirsch

(57) **Abstract**

To provide a high-frequency device capable of reliably attaching metal tape without causing damage to the metal tape, and thus obtaining an excellent shielding effect.

In a high-frequency device according to the present invention, the metal tape 9 comprises first and second separated adhesion portions 9b, 9c which are separable from each other by a cut portion 9a, a connected adhesion portion 9d for interconnecting the first and second separated adhesion portions 9b, 9c, and a hole 9e provided in the front end of the cut portion 9a; the first and second separated adhesion portions 9b, 9c are formed to be capable of being bent perpendicularly to the connected adhesion portion 9d; the first and second separated adhesion portions 9b, 9c of the metal tape 9 are attached to adjacent sidewalls 5a of the shield cover 5, respectively; and the connected adhesion portion 9d is attached on the circuit board 2 or on the upper surface of the shield frame 10 disposed in the case 1 in the proximity of the shield cover 5. Therefore, tensile force is not applied to the front end of the cut portion 9a, that is, it gets out of the hole 9e, therefore, the front end of the cut portion 9a will not get damaged.

## Description

The present invention relates to a high-frequency device adapted for a converter for receiving satellite broadcasting.

Referring to the drawings of the prior high-frequency device, Fig. 6 is an exploded perspective view showing a main part of the prior high-frequency device, Fig. 7 is a perspective view showing a main part related to the prior high-frequency device, and Fig. 8 is a plan view showing a shield tape related to the prior high-frequency device.

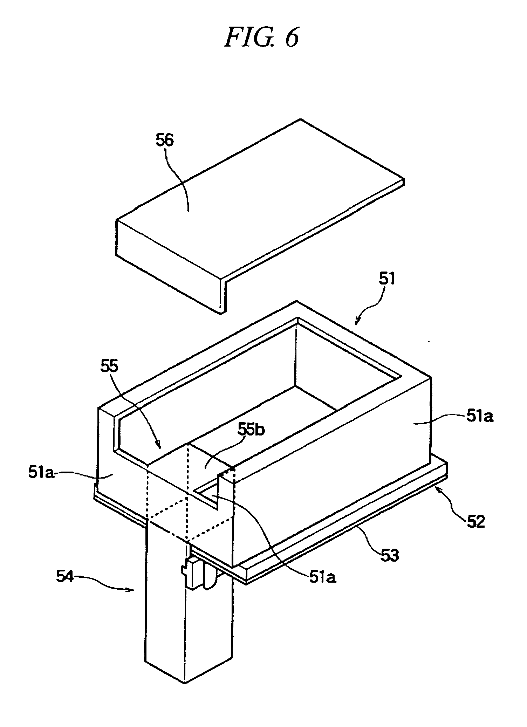

Reference will now be made to apply the configuration of the prior high-frequency device to a converter for receiving satellite broadcasting in conjunction with Fig. 6. A case 51 is formed by punching or bending a metal plate made of tinned iron. The case is formed with a wall portion 51a surrounding the four sides, with its top and bottom open.

A circuit board 52 formed of a printed circuit board has a ground pattern 53 for shielding provided over most of the lower surface of the circuit board 52, and a wiring pattern (not shown) provided in the upper surface where a variety of electronic components are mounted to form a desired receiving circuit.

The circuit board 52 is mounted in the case 51 so as to close the opening on the underside of the case 51, with electronic components located in the case 51.

By doing this, the opening on the lower side of the case 51 is electrically shielded by an earth pattern 53.

A tubular waveguide 54 is formed by bending a metal plate integrally formed with a case 51, and the waveguide 54 is disposed to project perpendicularly outward to a circuit board 52.

Further, satellite radio waves are introduced from the waveguide 54.

A box-shaped shield cover 55 is formed by bending a metal plate integrally formed with a case 51, and comprises a sidewall 55a for surrounding the four sides and an upper wall 55b for closing one end of the sidewalls 55a, with the other end of the sidewall 55a remaining open.

Also, the shield cover 55 is disposed to face a hollow of the waveguide 54, and is formed of a short cap constituting a short-circuit wall.

The shield cover 55 is located in the case 51, and the sidewall 55a is mounted perpendicularly to the circuit board 52.

Also, a lid 56 made of a metal plate is mounted in the case 51 so as to close an opening on the upper side of the case 51 (e.g., see Japanese Unexamined Patent Application Publication No. 2001-111256).

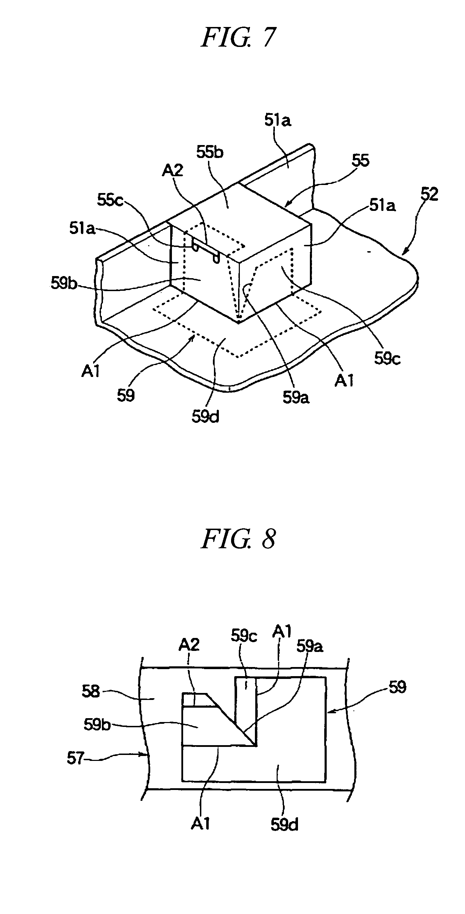

However, when such a shield cover 55 is processed, a gap 55c is formed between the sidewall 55a and the upper wall 55b, or a hole (not shown) is formed in the side wall 55a, as shown in Fig. 7.

Since the radio waves leak from the gap 55c or hole, if either exists in the shield cover 55, to affect the surrounding electric circuit, the gap 55c or hole is to be closed with metal tape 59.

Fig. 8 shows shield tape 57 used in the prior high-frequency device, wherein the shield tape 57 comprises paper tape 58 and metal tape 59 in which the paper tape is coated with an adhesive (not shown).

The metal tape 59 is made of an approximately rectangular foil material such as copper or aluminum, and comprises a cut portion 59a which is provided to incline, first and second separated adhesion portions 59b, 59c which are located on the left and right portions of the cut portion 59a and which are separable from each other, making the cut portion 59a a boundary, and a connected adhesion portion 59d which interconnects the first and second separated adhesion portions 59b, 59c.

The metal tape 59 is stripped from the paper tape 58, then the first and second separated adhesion portions 59b, 59c are bent perpendicularly to the connected adhesion portion 59d along the bend line A1 of Fig. 8, making the front end of the cut portion 59a as reference. Subsequently, as shown by the dotted line of Fig. 7, the bend line A1 is disposed on a basal part of the shield cover 55 and the connected adhesion portion 59d is then attached on the circuit board 52.

Next, a first separated adhesion portion 59b is attached to one of sidewalls 55a with the front end of the first separated adhesion portion 59b being pulled up, and then the front end of the first separated adhesion portion 59b is bent at the bend line A2 to attach to an upper wall 55b, thereby closing the gap 55c or hole.

Further, a second separated adhesion portion 59c is attached to one of the sidewalls 55a adjacent to the sidewall 55a which is attached to the first separated adhesion 59b, with the front end of the second separated adhesion portion 59c being pulled up, whereby attachment of the metal tape 59 is effected.

By attaching the second separated adhesion portion 59c to the sidewall 55a and attaching the connected adhesion portion 59d to the circuit board 52, the adhesion area of the metal tape 59 becomes large, thereby preventing the metal tape 59 from stripping.

However, a situation occurs when the metal tape 59 is attached: the front end of the cut portion 59a gets damaged since tensile force is applied to the front end when the first and second separated adhesion portions 59b, 59c are pulled up for the sake of good attachment.

In the prior high-frequency device, a problem has arisen in that since a cut portion 59a is provided in the metal tape 59 in order to make it possible to divide the first and second separated adhesion portions 59b, 59c, the front end of the cut portion 59a can get damaged since tensile force is applied to the front end when the first and second separated adhesion portions 59b, 59c are pulled up to attach the metal tape 59.

Accordingly, the object of the present invention is to provide a high-frequency device capable of reliably attaching the metal tape without causing damage to the metal tape, and thus obtaining an excellent shielding effect.

As the first solution to the above-mentioned problem, a high-frequency device according to the present invention is configured to comprise a case in which a circuit board is mounted, a box-shaped shield cover which is located in the case and mounted to the circuit board, and metal tape which is attached to the shield cover,
wherein the metal tape comprises first and second separated adhesion portions which are separable from each other by a cut portion, a connected adhesion portion for interconnecting the first and second separated adhesion portions, and a hole provided in the front end of the cut portion; the first and second separated adhesion portions are formed to be capable of being bent perpendicularly to the connected adhesion portion; the first and second separated adhesion portions are attached to adjacent sidewalls of the shield cover, respectively; and the connected adhesion portion is attached on the circuit board or on the upper surface of the shield frame disposed in the case in the proximity of the shield cover.

As the second solution to the above-mentioned problem, the first and second separated adhesion portions are configured to be bent at the position of the hole.

As the third solution to the above-mentioned problem, the hole is round or oval.

As the fourth solution to the above-mentioned problem, a bend-inducing portion for facilitating bending is provided in the bend portion between the connected adhesion portion and the first and second adhesion portions.

As the fifth solution to the above-mentioned problem, the shield cover has an upper wall for closing the end of the sidewall, and a separated adhesion portion is provided to close the gap between the upper wall and the sidewall and/or the hole portion in the sidewall.

As the sixth solution to the above-mentioned problem, the connected adhesion portion is attached to the upper wall of the shield frame to close the hole portion in the upper wall of the shield frame and/or the cutaway portion of the shield frame.

As the seventh solution to the above-mentioned problem, the connected adhesion portion is attached to extend to the case.

As the eighth solution to the above-mentioned problem, the shield cover is formed of a short cap of a converter for receiving satellite broadcasting.

A high-frequency device according to the present invention is configured to comprise a case in which a circuit board is mounted, a box-shaped shield cover which is located in the case and mounted to the circuit board, and metal tape which is attached to the shield cover,
wherein the metal tape comprises first and second separated adhesion portions which are separable from each other by a cut portion, a connected adhesion portion for interconnecting the first and second separated adhesion portions, and a hole provided in the front end of the cut portion; the first and second separated adhesion portions are formed to be capable of being bent perpendicularly to the connected adhesion portion; the first and second separated adhesion portions are attached to adjacent sidewalls of the shield cover, respectively; and the connected adhesion portion is attached on the circuit board or on the upper surface of the shield frame disposed in the case in the proximity of the shield cover.

By providing a hole in the front end of the cut portion in this way, tensile force is not applied to the front end of the cut portion, that is, it gets out of the hole; therefore, the front end of the cut portion will not get damaged.

Also, the first and second separated adhesion portions are allowed to have a margin on the bend location of the first and second separated adhesion portions since the first and second separated adhesion portions are bent at the position of the hole. It is therefore possible to attach without causing damage to the front end of the cut portion.

Also, since the hole is round or oval, and thus its rim is shaped like a circular arc, the stress concentration is minor when the metal tape is pulled up, whereby it is possible to attach without causing damage to the front end of the cut portion,.

Also, since the bend-inducing portion for facilitating bending is provided in the bend portion between the connected adhesion portion and the first and second separated adhesion portions, it is possible to readily practice bending on the predetermined location (the location of the bend-inducing portion) and thus to attach very precisely.

Also, since the shield cover has an upper wall for closing the end of the sidewall, and a separated adhesion portion is provided to close the gap between the upper wall and the sidewall and/or the hole portion in the sidewall, it is possible to reliably shield the gap or the hole portion of the shield cover.

Also, it is possible to augment the attachment strength since the connected adhesion portion is attached to the upper wall to close the hole portion in the upper wall of the shield frame and/or the cutaway portion of the shield frame, and it is possible to reduce the leakage of radio waves from the hole or cutaway portion since the hole or cutaway portion is closed.

Also, since the connected adhesion portion is attached to extend to the case, it is possible not only to augment the attachment strength but to reduce the leakage of radio waves toward the upper side between the wall portion and the shield frame.

Also, since the shield cover is formed of a short cap of a converter for receiving satellite broadcasting, it is especially adapted for a converter for receiving satellite broadcasting in which the leakage of radio waves greatly affects performance.

A high-frequency device according to the present invention will be set forth in conjunction with the drawings.

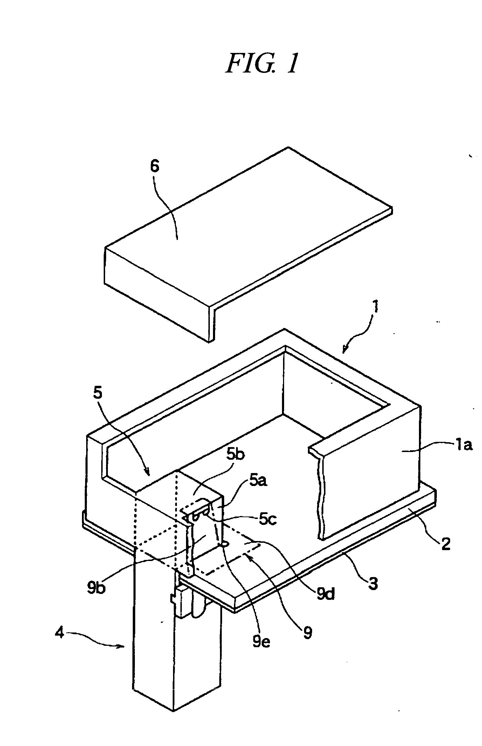

Fig. 1 is an exploded perspective view showing a main part of a high-frequency device according to the present invention.

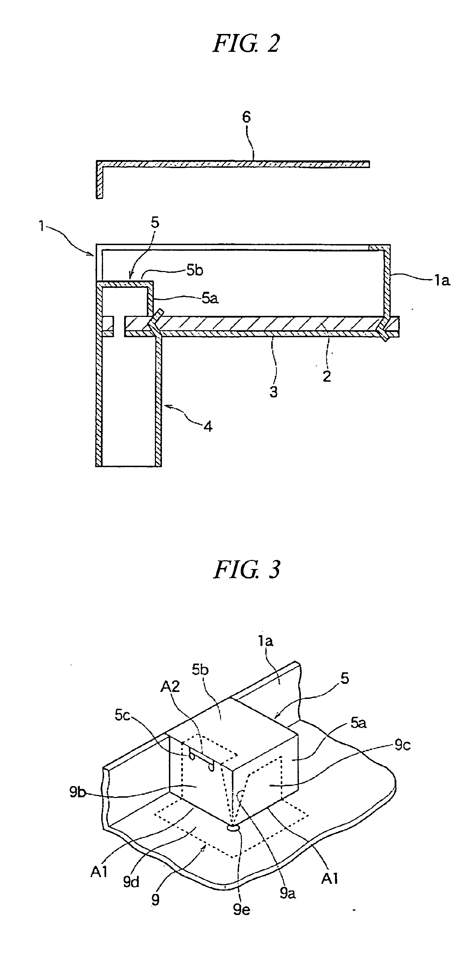

Fig. 2 is a sectional view showing a main part of a high-frequency device according to the present invention.
Fig. 3 is a perspective view showing a main part reduced to a high-frequency device according to the present invention.

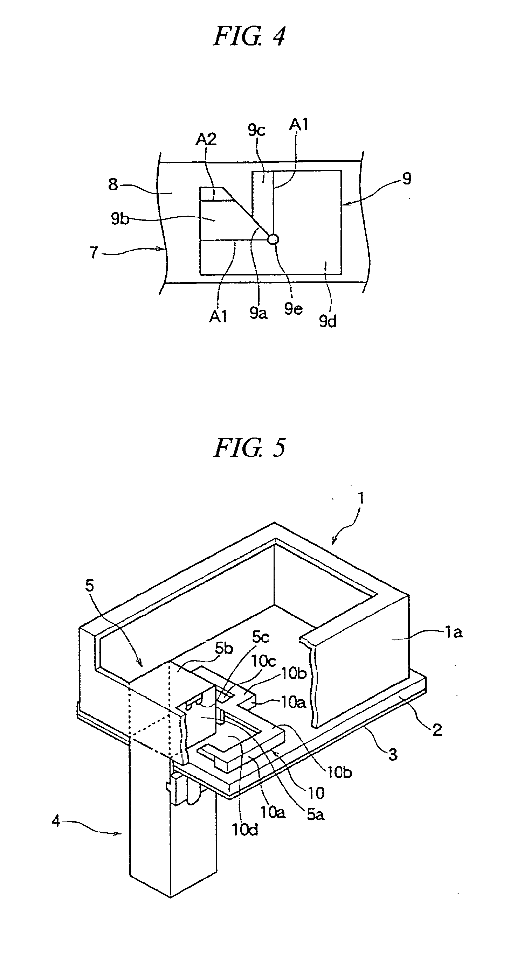

Fig. 4 is a plan view showing a shield tape related to a high-frequency device according to the present invention.
Fig. 5 is a perspective view showing a main part whose portion is cut, in connection with another embodiment of the high-frequency device according to the present invention.
Fig. 6 is an exploded perspective view showing a main part of the prior high-frequency device.
Fig. 7 is a perspective view showing a main part of the high-frequency device.
Fig. 8 is a plan view showing a shield tape related to the high-frequency device.

Next, reference will be made to apply the configuration of a high-frequency device according to the present invention to a converter for receiving satellite broadcasting in conjunction with Figs. 1 to 4. A case 1 is formed by punching or bending a metal plate made of tinned iron, and has a wall portion 1a surrounding the four sides, with its top and bottom open.

A circuit board 2 formed of a printed circuit board has a ground pattern 3 for shielding which is provided over most of the lower surface of the circuit board, and a wiring pattern (not shown) provided in the upper surface where a variety of electronic components are mounted to form a desired receiving circuit.

The circuit board 2 is mounted in the case 1 so as to close the opening on the underside of the case 1, with electronic components located in the case 1.

In this way, the opening on the underside of the case 1 is electrically shielded by an earth pattern 3.

A tubular waveguide 4 is formed by bending a metal plate integrally formed with a case 1, and the waveguide 4 is disposed to project perpendicularly outward to a circuit board 2.

Also, satellite radio waves are introduced from the waveguide 4.

A box-shaped shield cover 5 is formed by bending a metal plate integrally formed with a case 1, and comprises a sidewall 5a for surrounding the four sides and an upper wall 5b for closing one end of the sidewalls 5a, with the other end of the sidewall 5a remaining open.

Also, the shield cover 5 is disposed to face a hollow of the waveguide 4, and is formed of a short cap constituting a short-circuit wall.

The shield cover 5 is located in the case 1, and the sidewall 5a is mounted perpendicularly to the circuit board 2.

Also, a lid 6 made of a metal plate is mounted in the case 1 so as to close an opening on the upper side of the case 1.

However, when such a shield cover 5 is processed, a gap 5c is formed between the sidewall 5a and the upper wall 5b, or a hole portion (not shown) is formed in the side wall 5a, as shown in Figs. 1 and 3.

Since radio waves leak from the gap 5c or hole portion, if either exists in the shield cover, to affect the surrounding electric circuit, the gap 5c or hole portion is to be closed with metal tape 9.

Fig. 4 shows shield tape 7 used in a high-frequency device according to the present invention, wherein the shield tape comprises paper tape 8 and metal tape 9 in which the paper tape 8 is coated with an adhesive (not shown).

The metal tape 9 is made of an approximately rectangular foil material such as copper or aluminum, and comprises a cut portion 9a which is provided to incline, first and second separated adhesion portions 9b, 9c which are located on the left and right portion of the cut portion 9a and which are separable from each other, making the cut portion 9a a boundary, a connected adhesion portion 9d which interconnects the first and second separated adhesion portions 9b, 9c, and a hole 9e provided in the front end of the cut portion 9a.

The hole 9e may be of the shape of a circle, an oval, or anything else. If it is circular, or oval with a rim in the shape of a circular arc, it is especially effective since the stress concentration is minor.

The metal tape 9 is stripped from the paper tape 8, then the first and second separated adhesion portions 9b, 9c are bent perpendicularly to the connected adhesion portion 9d along the bend line A1 of Fig. 4, making the front end of the cut portion 9a or the hole 9e a reference. Subsequently, as shown by the dotted line of Fig. 3, the bend line A1 is disposed on a basal part of the shield cover 5 and the connected adhesion portion 9d is then attached on the circuit board 2.

While not shown here, a bend-inducing portion for inducing bending, such as a tear-off, a cut portion, or a depression, is provided in the bend lines A1, A2, thereby facilitating bending at a predetermined position (a position of the bend-inducing portion).

Next, a first separated adhesion portion 9b is attached to one of the sidewalls 5a, with the front end of the first separated adhesion portion 9b being pulled up, and then the front end of the first separated adhesion portion 9b is bent at the bend line A2 to attach to an upper wall 5b, thereby closing the gap 5c or hole portion.

Further, a second separated adhesion portion 9c is attached to one of the sidewalls 5a adjacent to the sidewall 5a attached to the first separated adhesion 9b with the front end of the second separated adhesion portion 9c being pulled up, whereby attachment of the metal tape 9 is effected.

By attaching the second separated adhesion portion 9c to the sidewall 5a and attaching the connected adhesion portion 9d to the circuit board 2, the adhesion area of the metal tape 9 becomes large, thereby preventing the metal tape 9 from stripping.

Also, while not shown here, if the connected adhesion portion 9d is attached to the case 1, as well, the metal tape 9 is more reliably prevented from stripping.

Also, when the metal tape 9 is attached, the first and second separated adhesion portions 9b, 9c are pulled up for the sake of good attachment. At this time, since tensile force is not applied to the front end of the cut portion 9a, due to the hole 9e, that is, it gets out of the hole 9a, the front end of the cut portion 9a will not get damaged.

Another embodiment of the high-frequency device according to the present invention will be set forth in conjunction with Fig. 5. A shield frame 10 is formed by punching and bending metal plate, and comprises a sidewall 10a which is soldered to a circuit board 2, an upper wall 10b which is connected to the sidewall 10a and covers the upper side, a hole portion 10c which is provided in the upper wall 10b, and a cutaway portion 10d.

The shield frame 10 is disposed in the proximity of the shield cover 5 so as to shield the electric circuit provided in the proximity of the shield cover 5.

While not shown in Fig. 5, the first and second separated adhesion portions 9b, 9c of the metal tape 9 are attached to the sidewalls 5a and the upper wall 5b of the shield cover 5, as in the above-mentioned embodiment, but the connected adhesion portion 9d is attached to the wall portion 1a of the case 1 as well as to the upper wall 10b so as to close the hole portion 10c and the cutaway portion 10d of the shield frame 10.

That is, the attachment strength is augmented by attaching metal tape 9 to the upper wall 10b of the shield frame 10, and the leakage of radio waves from the hole portion 10c or the cutaway portion 10d is reduced by closing the hole portion 10c or the cutaway portion 10d. In addition, the attachment strength is augmented and the leakage of radio waves toward the upper side between the wall portion 1a and the shield frame 10 is reduced by attaching metal tape 9 to the wall portion 1a of the case 1.

Since the rest of the configuration is the same as the above-mentioned embodiment, the same components are indicated by the same reference numerals and description is omitted.

Moreover, although it has been described in the above-mentioned embodiments that the shield cover 5 is formed of a short cap, it may be adapted to a shield cover for shielding an amplifier circuit or any other electric circuits.

Further, although it has been described that the above-mentioned embodiments are applied to a high-frequency device or converter for receiving satellite broadcasting, it may be applied to any other high-frequency devices.

### Reference Numerals:

- 1:: CASE
- 1a:: WALL PORTION
- 2:: CIRCUIT BOARD
- 3:: GROUND PATTERN
- 4:: WAVEGUIDE
- 5:: SHIELD COVER
- 5a:: SIDEWALL
- 5b:: UPPER WALL
- 5c:: GAP
- 6:: LID
- 7:: SHIELD TAPE
- 8:: PAPER TAPE
- 9:: METAL TAPE
- 9a:: CUT PORTION
- 9b:: FIRST SEPARATED ADHESION PORTION
- 9c:: SECOND SEPARATED ADHESION PORTION
- 9d:: CONNECTED ADHESION PORTION
- 9e:: HOLE
- A1:: BEND LINE
- A2:: BEND LINE
- 10:: SHIELD FRAME
- 10a:: SIDEWALL
- 10b:: UPPER WALL
- 10c:: HOLE PORTION
- 10d:: CUTAWAY PORTION

## Claims

1. A high-frequency device comprising:
a case in which a circuit board is mounted;
a box-shaped shield cover which is located in the case and mounted to the circuit board; and
metal tape attached to the box-shaped shield cover,
wherein the metal tape comprises first and second separated adhesion portions which are separable from each other by a cut portion, a connected adhesion portion for interconnecting the first and second separated adhesion portions, and a hole provided in the front end of the cut portion,
the first and second separated adhesion portions are formed to be capable of being bent perpendicularly to the connected adhesion portion,
the first and second separated adhesion portions are attached to adjacent sidewalls of the shield cover, respectively, and
the connected adhesion portion is attached on the circuit board, or on the upper surface of the shield frame disposed in the case in the proximity of the shield cover.

2. The high-frequency device according to Claim 1,
wherein the first and second separated adhesion portions are bent at the position of the hole.

3. The high-frequency device according to Claim 1 or 2,
wherein the hole is round or oval.

4. The high-frequency device according to any one of Claims 1 to 3,
wherein a bend-inducing portion for facilitating bending is provided in a bend portion between the connected adhesion portion and the first and second separated adhesion portions.

5. The high-frequency device according to any one of Claims 1 to 4,
wherein the shield cover has an upper wall for closing the end of the sidewall, and the separated adhesion portion is provided to close the gap between the upper wall and the sidewall and/or a hole portion in the sidewall.

6. The high-frequency device according to any one of Claims 1 to 5,
wherein the connected adhesion portion is attached to the upper wall of the shield frame to close a hole portion in the upper wall of the shield frame and/or a cutaway portion of the shield frame.

7. The high-frequency device according to any one of Claims 1 to 6,
wherein the connected adhesion portion is attached to extend to the case.

8. The high-frequency device according to any one of Claims 1 to 7,
wherein the shield cover is formed of a short cap of a converter for receiving satellite broadcasting.
